# DEMANDE DE BREVET EUROPEEN

(11) **EP 1 191 681 A2**
(43) Date de publication de la demande: **27.03.2002**
(21) Numéro de dépôt: 01203587.9
(22) Date de dépôt: 21.09.2001
(51) Int. Cl.: H03B 21/02, H03B 19/12

(54) **Source de signal à filtre polyphase**

(30) Priorité: 25.09.2000 FR 0012167
(71) Demandeur: Koninklijke Philips Electronics N.V., 5621 BA Eindhoven (NL)
(72) Inventeur: Brunel, Dominique, 75008 Paris (FR); Cercelaru, Sever, 75008 Paris (FR)
(74) Mandataire: Chaffraix, Jean

(57) **Abrégé**

L'invention concerne une source de signal (S) comprenant un oscillateur local (5) qui génère un signal de fréquence de référence fo. La source de signal comprend :
- un diviseur de fréquence par N (6) qui délivre deux signaux carrés en quadrature (Id, Qd) à la fréquence fo/N, N étant égal à 2 où à 4xn, n étant un nombre entier, et
- un filtre polyphase (7) qui délivre, à partir des deux signaux carrés en quadrature (Id, Qd), deux signaux sinusoïdaux en quadrature (Is, Qs) à une fréquence égale à m.fo/N, m étant un nombre impair.

L'invention s'applique aux circuits de conversion directe de fréquence et aux circuits d'émission utilisés dans le domaine des télécommunications.

## Description

L'invention concerne une source de signal ainsi qu'un procédé de formation de signal.

L'invention concerne également un circuit de conversion de fréquence ainsi qu'un procédé de conversion de fréquence, un circuit d'émission de signal ainsi qu'un procédé de formation de signal d'émission, un circuit d'émission/réception de signal et un appareil téléphonique.

Un domaine d'application de l'invention est le domaine des télécommunications tel que, par exemple, le domaine de la téléphonie cellulaire.

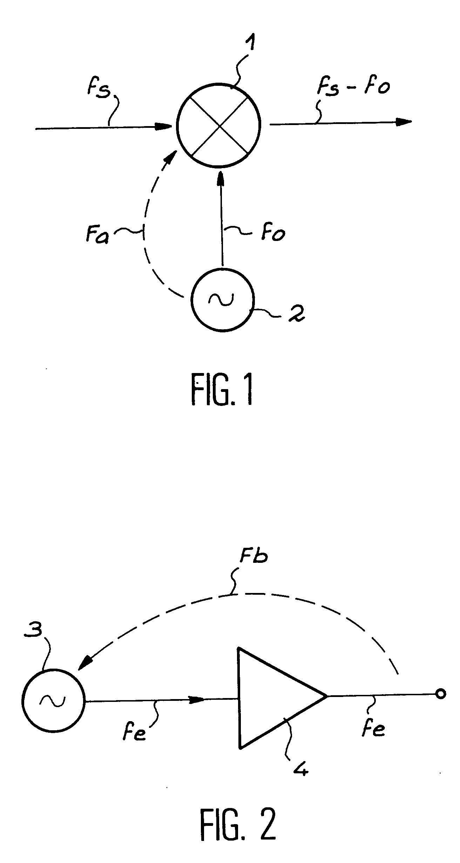

Un convertisseur de fréquence selon l'art connu est représenté en figure 1. Le convertisseur de fréquence comprend un mélangeur 1 et un oscillateur local 2. Le mélangeur 1 reçoit, sur une première entrée (par la suite nommée "entrée signal"), un signal de fréquence fs contenant des données à détecter et, sur une deuxième entrée, un signal de fréquence fo issu de l'oscillateur local. Le signal utile délivré en sortie du mélangeur est un signal dont la fréquence est égale à la différence des fréquences fs et fo.

Dans le cas d'une conversion directe de fréquence, les fréquences fs et fo sont soit sensiblement égales, soit séparées, par exemple, de quelques centaines de kHz. L'information utile est alors délivrée soit sous la forme d'un signal continu soit sous la forme d'un signal de très basse fréquence.

Par rayonnement, une fraction Fa du signal émis par l'oscillateur local peut être détectée sur l'entrée signal du mélangeur 1. Ce phénomène de détection du signal issu de l'oscillateur local est communément appelé "auto-mélange". La détection par auto-mélange conduit à la présence, en sortie du mélangeur 1, d'un signal continu parasite qui vient s'ajouter au signal utile. Supprimer cette composante parasite sans altérer le signal utile est très délicat et nécessite des moyens complexes et coûteux, particulièrement dans les dispositifs à conversion directe de fréquence.

Un circuit d'émission de signal selon l'art antérieur est représenté en figure 2. Le circuit comprend un oscillateur local 3 et un amplificateur 4. L'oscillateur local 3 délivre un signal de fréquence fe qui est amplifié par l'amplificateur 4. Une fraction Fb du signal de fréquence fe délivré par l'amplificateur 4 est très souvent rayonnée et re-émise vers l'oscillateur local qui se comporte alors comme un récepteur sélectif à la fréquence fe. Le signal ainsi reçu par l'oscillateur local perturbe les conditions d'établissement de la fréquence fe qui, en conséquence, se trouve modifiée. Ce phénomène de modification de fréquence sous l'action du circuit de charge de l'oscillateur local est communément appelé "pulling".

Afin de réduire le phénomène de pulling, il est connu de placer un diviseur de fréquence entre l'oscillateur local et l'amplificateur. Cette technique est décrite dans la demande de brevet européen EP 0 926 811-A1. Afin de conserver la même fréquence de référence, la fréquence de l'oscillateur local est, par exemple, multipliée par 2 alors que le diviseur de fréquence divise par 2 la fréquence du signal issu de l'oscillateur local. Le signal en sortie de l'amplificateur A comprend non seulement le signal de fréquence fe mais également des harmoniques du signal de fréquence fe. Ce n'est alors plus le signal de fréquence fe qui perturbe les conditions d'établissement de la fréquence de l'oscillateur local mais l'harmonique de rang 2. L'harmonique de rang 2 a un niveau de puissance très sensiblement inférieur au niveau de puissance du fondamental. La stabilité de fréquence de l'oscillateur local s'en trouve améliorée, mais le problème du pulling n'est pas pour autant résolu.

L'invention ne présente pas les inconvénients mentionnés ci-dessus.

### Exposé de l'invention

En effet, l'invention concerne une source de signal comprenant un oscillateur local pour générer un signal de fréquence de référence fo. La source de signal comprend :
- un diviseur de fréquence par N relié à l'oscillateur local et destiné à délivrer deux signaux carrés en quadrature à la fréquence fo/N, N étant égal à 2 ou à 4.n, n étant un nombre entier, et
- un filtre polyphase relié au diviseur de fréquence pour délivrer, à partir des signaux en quadrature issus du diviseur de fréquence, deux signaux sinusoïdaux en quadrature à une fréquence égale à m.fo/N, m étant un nombre impair.

L'invention concerne également un circuit de conversion de fréquence comprenant un mélangeur et une source de signal telle que décrite ci-dessus.

L'invention concerne encore un circuit d'émission de signal comprenant une source de signal pour délivrer un signal à une fréquence d'émission et un amplificateur pour amplifier le signal issu de la source de signal, laquelle est telle que décrite plus haut.

L'invention concerne encore un circuit d'émission/réception comprenant un circuit d'émission de signal et un circuit de conversion de fréquence tels que décrits ci-dessus.

L'invention concerne encore un appareil téléphonique comprenant un circuit d'émission de signal tel que décrit plus haut ou un circuit d'émission/réception tel que décrit plus haut.

L'invention concerne encore un procédé de formation de deux signaux sinusoïdaux en quadrature (Is, Qs) à partir d'un signal de fréquence fo. Le procédé comprend :
- la formation de deux signaux carrés en quadrature (Id, Qd) à la fréquence fo/N, N étant égal à 2 ou 4.n, n étant un nombre entier, et
- la formation, à partir des deux signaux carrés en quadrature (Id, Qd), des deux signaux sinusoïdaux en quadrature (Is, Qs) à une fréquence égale à m.fo/n, m étant un nombre impair.

L'invention concerne encore un procédé de conversion directe d'un signal de fréquence fs en un signal de fréquence fd, qui comprend
- un procédé de formation de deux signaux sinusoïdaux en quadrature (Is, Qs) tel que décrit ci-dessus, et
- une étape de mélange de chacun des deux signaux sinusoïdaux en quadrature (Is, Qs) avec le signal de fréquence fs pour délivrer le signal de fréquence fd.

L'invention concerne encore un procédé de formation d'un signal d'émission, qui comprend :
- un procédé de formation de deux signaux sinusoïdaux en quadrature (Is, Qs) tel que décrit plus haut, et
- une étape d'amplification d'au moins l'un des deux signaux sinusoïdaux en quadrature (Is, Qs) pour former le signal d'émission.

La source de signal selon l'invention délivre un signal dont la fréquence n'a pas de rapport harmonique avec la fréquence de l'oscillateur local. Avantageusement, les phénomènes d'auto-mélange et de pulling sont ainsi totalement supprimés.

### Brève description des figures

D'autres caractéristiques et avantages de l'invention apparaîtront à la lecture d'un mode de réalisation préférentiel fait en référence aux figures jointes parmi lesquelles :
- la figure 1 représente un circuit de conversion de fréquence selon l'art antérieur,
- la figure 2 représente un circuit d'émission de signal selon l'art antérieur,
- la figure 3 représente une source de signal selon l'invention,
- la figure 4 représente un circuit de conversion de fréquence selon l'invention,
- les figures 5A, 5B et 5C représentent trois modes de réalisation d'un circuit d'émission de signal selon l'invention,
- les figures 6A, 6B et 6C représentent trois modes de réalisation d'un circuit d'émission/réception selon l'invention,
- la figure 7 représente un appareil téléphonique selon l'invention.

Sur toutes les figures, les mêmes signes de référence désignent les mêmes éléments.

### Description détaillée de modes de mise en oeuvre de l'invention

Les figures 1 et 2 ont été décrites précédemment, il est donc inutile d'y revenir.

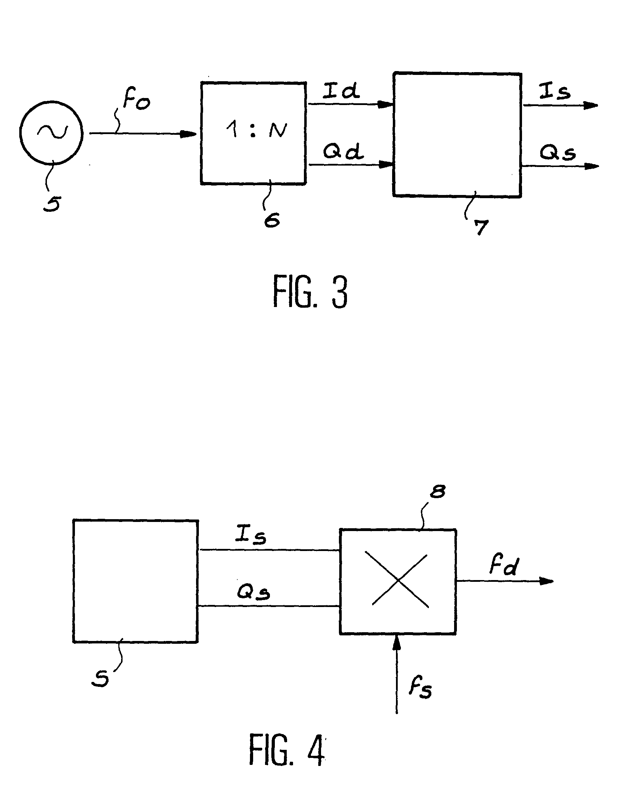

La figure 3 représente une source de signal selon l'invention.

La source de signal comprend un oscillateur 5, un diviseur de fréquence 6 et un filtre polyphase 7. L'oscillateur 5 délivre un signal de fréquence de référence fo qui est transmis au diviseur de fréquence 6. Le diviseur de fréquence 6 est un diviseur par N qui délivre deux signaux en quadrature Id et Qd, le nombre N étant égal à 2 ou à 4.n, avec n entier. Les signaux en quadrature Id et Qd issus du diviseur 6 sont des signaux sensiblement carrés de fréquence fo/N dont le facteur de forme est sensiblement égal à 50%. Le signal en sortie du diviseur 6 est alors constitué d'un signal sinusoïdal de fréquence fo/N et d'harmoniques de fréquence m.fo/N, où m est un nombre impair.

Selon l'invention, le filtre polyphase 7 est réglé de façon à ne transmettre qu'un seul harmonique de fréquence m.fo/N. Préférentiellement, m=3. La fréquence des signaux Is et Qs disponibles en sortie du filtre polyphase n'est alors pas un multiple entier de la fréquence fo de l'oscillateur local (en effet, le nombre m étant impair et le nombre N étant pair, il s'ensuit que le rapport m/N est un nombre fractionnaire).

Comme cela va apparaître ci-dessous, le phénomène d'auto-mélange relatif au circuit de conversion de fréquence, de même que le phénomène de "pulling" relatif au circuit d'émission sont alors totalement supprimés.

La figure 4 représente un circuit de conversion de fréquence selon l'invention.

Ce circuit de conversion comprend une source de signal S et un mélangeur 8. La source S est constituée d'un oscillateur local 5, d'un diviseur de fréquence 6 et d'un filtre polyphase 7 tels que décrits en figure 3. Le mélangeur 8 reçoit, d'une part, le signal de fréquence fs contenant les informations à détecter et d'autre part, le signal de référence issu de la source S et constitué des signaux Is et Qs en quadrature.

La source S délivre un signal dont la fréquence n'a pas de rapport harmonique avec la fréquence de l'oscillateur local 5. Le phénomène d'auto-mélange est alors totalement supprimé. L'isolation du circuit de conversion peut ainsi se trouver améliorée, par exemple, de l'ordre de 20 dB.

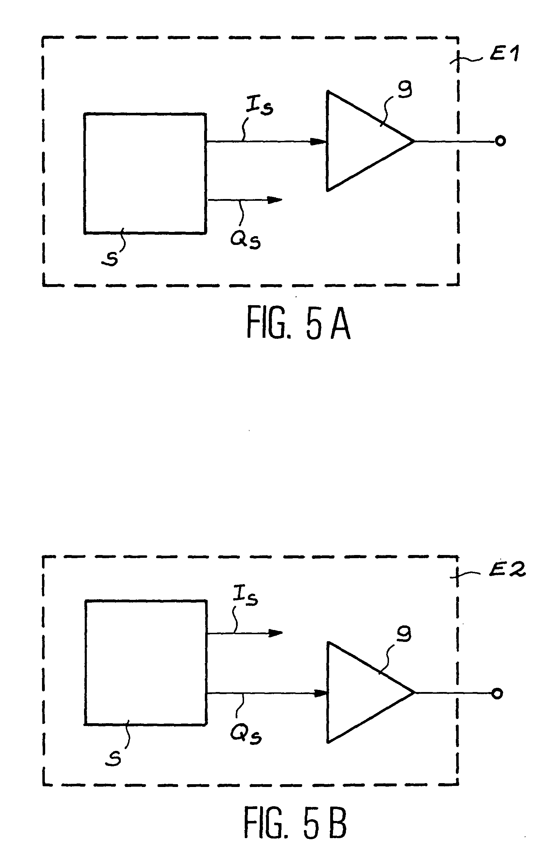

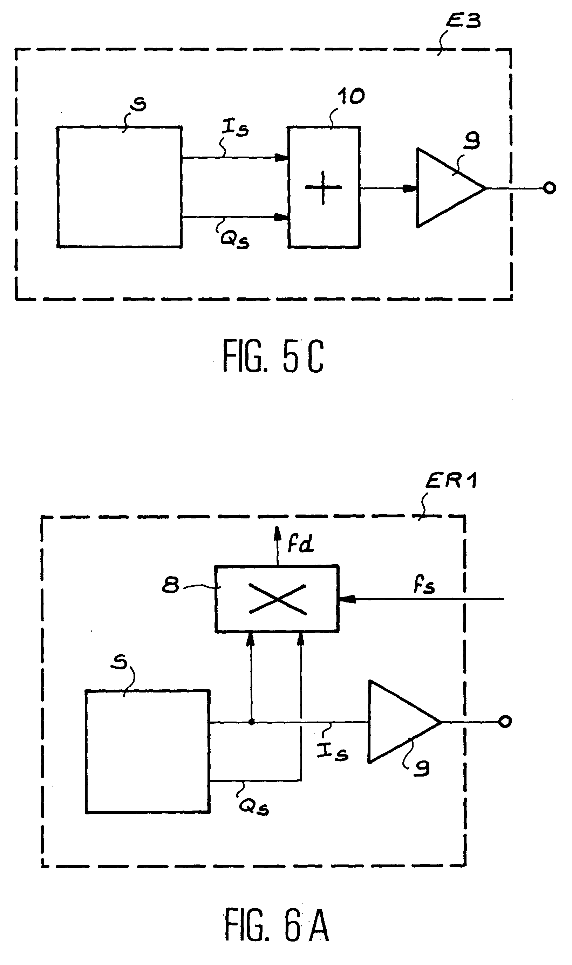

Les figures 5A, 5B et 5C représentent trois modes de réalisation d'un circuit d'émission de signal selon l'invention.

L'émetteur à état solide comprend une source de signal S telle que décrite en figure 3 et un amplificateur 9. Le circuit d'émission E1 de la figure 5A représente le cas où la composante Is de phase nulle constitue le signal d'entrée de l'amplificateur 9 et le circuit d'émission E2 de la figure 5B représente le cas où la composante Qs, déphasée de π/2 par rapport à la composante Is, constitue le signal d'entrée de l'amplificateur 9. Les signaux Is et Qs peuvent également être additionnés dans un sommateur 10 pour ne former qu'un seul signal en entrée de l'amplificateur 9, comme représenté en figure 5C (circuit d'émission E3). L'amplitude du signal en entrée de l'amplificateur 9 est alors accrue d'un facteur multiplicatif égal à √2.

La fréquence du signal d'entrée de l'amplificateur n'a pas de rapport harmonique avec la fréquence de l'oscillateur de référence 5. Il s'ensuit que le phénomène de pulling est totalement supprimé.

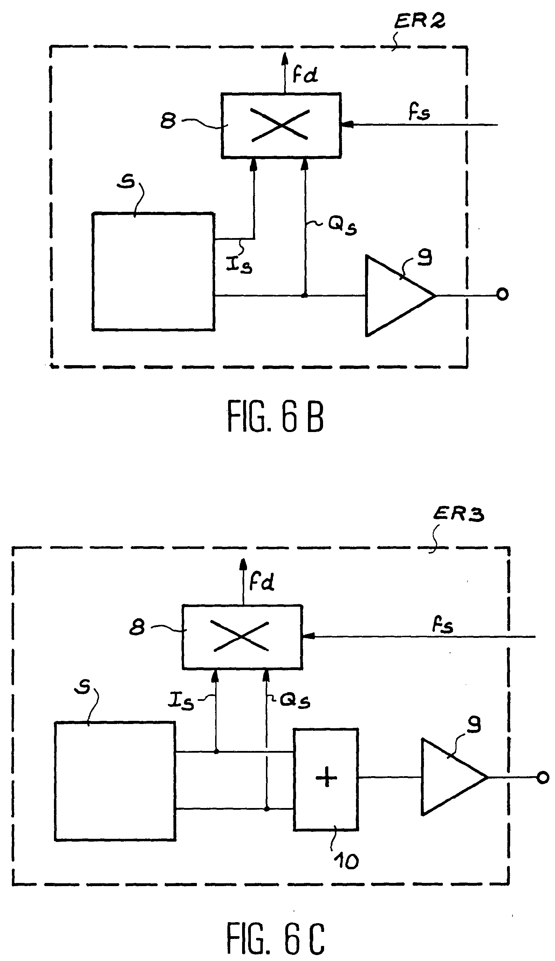

Les figures 6A, 6B et 6C représentent trois modes de réalisation d'un circuit d'émission/réception selon invention. Le circuit d'émission/réception selon l'invention trouve une application particulièrement avantageuse dans les systèmes communément appelés systèmes TDMA (l'acronyme TDMA étant issu de l'expression anglaise "Time Division Multiple Access").

Le circuit d'émission/réception ER1 représenté en figure 6A comprend un circuit d'émission tel que représenté en figure 5A et un circuit de conversion de fréquence tel que représenté en figure 4.

Le circuit d'émission/réception ER2 représenté en figure 6B comprend un circuit d'émission tel que représenté en figure 5B et un circuit de conversion tel que représenté en figure 4.

Le circuit d'émission/réception ER3 représenté en figure 6C comprend un circuit d'émission tel que représenté en figure 5C et un circuit de conversion tel que représenté en figure 4.

Pour chaque circuit ER1, ER2, ER3, la même source S est commune au circuit d'émission et au circuit de conversion.

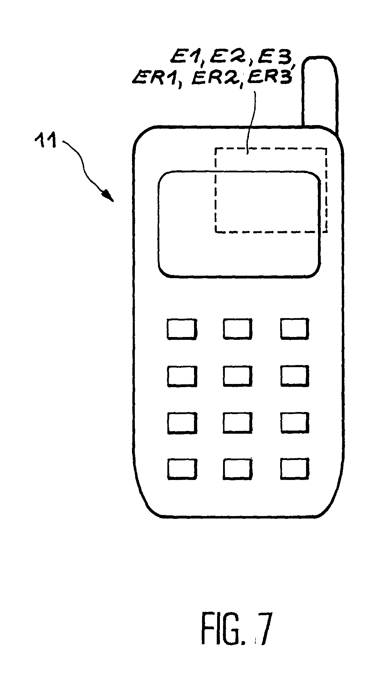

La figure 7 représente un appareil téléphonique selon l'invention.

L'appareil téléphonique 11, par exemple un téléphone mobile, contient un circuit d'émission selon l'invention tel qu'un circuit E1, E2 ou E3, ou un circuit d'émission/réception selon l'invention tel qu'un circuit ER1, ER2, ou ER3.

## Revendications

1. Source de signal (S) comprenant un oscillateur local (5) destiné à générer un signal de fréquence de référence fo, **caractérisée en ce qu'**elle comprend :
- un diviseur de fréquence par N (6) relié à l'oscillateur local (5) et destiné à fournir deux signaux carrés en quadrature (Id, Qd) à la fréquence fo/N, N étant égal à 2 où à 4.n, n étant un nombre entier, et
- un filtre polyphase (7) relié au diviseur de fréquence (6) pour délivrer, à partir des deux signaux carrés en quadrature (Id, Qd) issus du diviseur de fréquence (6), deux signaux sinusoïdaux en quadrature (Is, Qs) à une fréquence égale à m.fo/N, m étant un nombre impair.

2. Source de signal selon la revendication 1, **caractérisée en ce que** m=3.

3. Circuit de conversion de fréquence comprenant un mélangeur (8) et une source de signal de fréquence de référence (S), **caractérisé en ce que** la source de signal (S) est une source selon l'une quelconque des revendications 1 ou 2.

4. Circuit d'émission de signal (E1, E2, E3) comprenant une source de signal (S) pour délivrer un signal à une fréquence d'émission et un amplificateur (9) pour amplifier le signal issu de la source de signal (S), **caractérisé en ce que** la source de signal (S) est une source selon l'une quelconque des revendications 1 ou 2.

5. Circuit d'émission/réception (ER1, ER2, ER3) comprenant un circuit d'émission de signal et un circuit de conversion de fréquence, **caractérisé en ce que** le circuit d'émission de signal est un circuit selon la revendication 4 et **en ce que** le circuit de conversion de fréquence est un circuit selon la revendication 3, la même source de signal (S) étant commune au circuit d'émission et au circuit de conversion de fréquence.

6. Appareil téléphonique (11) comprenant un circuit d'émission, **caractérisé en ce que** le circuit d'émission (E1, E2, E3) est un circuit selon la revendication 4.

7. Appareil téléphonique (11) comprenant un circuit d'émission/réception, **caractérisé en ce que** le circuit d'émission/réception (ER1, ER2, ER3) est un circuit selon la revendication 5.

8. Procédé de formation de deux signaux sinusoïdaux en quadrature de phase (Is, Qs) à partir d'un signal de fréquence fo, incluant les étapes suivantes :
- formation de deux signaux carrés en quadrature (Id, Qd) à la fréquence fo/N, N étant égal à 2 ou 4.n, n étant un nombre entier, et
- formation, à partir des deux signaux carrés en quadrature (Id, Qd), des deux signaux sinusoïdaux en quadrature (Is, Qs) à une fréquence égale à m.fo/n, m étant un nombre impair.

9. Procédé de conversion d'un signal de fréquence fs en un signal de fréquence fd, incluant :
- un procédé de formation de deux signaux sinusoïdaux en quadrature (Is, Qs) selon la revendication 8, et
- une étape de mélange de chacun des deux signaux sinusoïdaux en quadrature (Is, Qs) avec le signal de fréquence fs pour délivrer le signal de fréquence fd.

10. Procédé de formation d'un signal d'émission, incluant :
- un procédé de formation de deux signaux sinusoïdaux en quadrature (Is, Qs) selon la revendication 8, et
- une étape d'amplification d'au moins l'un des deux signaux sinusoïdaux en quadrature (Is, Qs) pour former le signal d'émission.
